# EUROPEAN PATENT APPLICATION

(11) **EP 4 414 971 A1**
(43) Date of publication of application: **14.08.2024**
(21) Application number: 22878502.8
(22) Date of filing: 04.10.2022
(51) Int. Cl.: G09F 13/12, D06N 3/00, G09F 13/04

(54) **LEATHER-TEXTURED LIGHT-EMITTING DISPLAY DEVICE**

(30) Priority: 06.10.2021 JP 2021165024
(71) Applicant: Kuraray Co., Ltd., Kurashiki-shi, Okayama 710-0801 (JP)
(72) Inventor: MATSUDA Daisuke, Okayama-shi, Okayama 702-8601 (JP); WARITA Masato, Okayama-shi, Okayama 702-8601 (JP); MAKIYAMA Norio, Okayama-shi, Okayama 702-8601 (JP)
(74) Representative: Vossius & Partner Patentanwälte Rechtsanwälte mbB
(86) International application number: PCT/JP2022/037068
(87) International publication number: WO 2023/058633

(57) **Abstract**

Disclosed is a leather-like light-emitting display device, including: a leather-like sheet that is a laminate of a colored resin layer forming an outer surface layer, and a fiber substrate; a light-emitting portion disposed below the leather-like sheet; and a light-blocking portion configured to partially limit transmission of light, and interposed between any layers from the colored resin layer to the light-emitting portion, wherein the leather-like light-emitting display device is configured to exhibit light-emitting display with a luminance Ya of 200 cd/m² or less in a non-light emitting region corresponding to the light-blocking portion and a luminance Yb of 100 to 2,000 cd/m² in a light-emitting region corresponding to a portion other than the light-blocking portion, both as measured from a surface of the colored resin layer, and Yb/Ya being 2.0 or more.

## Description

### [Technical Field]

The present invention relates to a light-emitting display device having a leather-like appearance and being configured to display characters, diagrams, patterns, and the like by light emission.

### [Background Art]

With the recent diversification of consumer tastes and preferences, there is a need for materials having a novel design for decorating the surface of articles. Under such a circumstance, there have been proposed light-emitting display devices in which a lighting device such as a backlight or a liquid crystal panel including a backlight is disposed on a back surface of a colored sheet, then the lighting device is caused to emit light, and the light is transmitted through the sheet, thus causing characters, diagrams, patterns and the like to appear on the surface of the sheet.

PTL 1 listed below discloses a synthetic leather including a raw fabric, and a skin layer made of a polyurethane resin and stacked on the raw fabric, wherein the synthetic leather has a visible light transmittance of 0.10 to 11.90% for a wavelength range of 380 to 780 nm.

PTL 1 discloses a black synthetic leather obtained by stacking, on a raw fabric that is a black polyester knitted fabric, a skin layer colored in black using a black pigment (trade name "Dirac L-1770" manufactured by DIC Corporation), wherein the synthetic leather has a visible light transmittance of 0.17 to 0.20% for a wavelength range of 380 to 780 nm.

In addition, PTL 1 discloses a white synthetic leather obtained by stacking, on a raw fabric that is a white polyester knitted fabric, a skin layer colored in white using a white pigment (trade name "Dirac L-1781" manufactured by DIC Corporation), wherein the synthetic leather has a visible light transmittance of 10.87 to 11.90% for a wavelength range of 380 to 780 nm.

PTL 2 listed below discloses a light-transmissive artificial leather sheet in which a transparent or semi-transparent elastomer sheet is used. This artificial leather sheet includes a smoke print layer on a back surface or a front surface of an elastomer sheet, and includes, on an outermost layer of the back surface of the elastomer sheet, a mask print layer for causing a character, a figure, a pattern, or a design including combination thereof to appear, and a leather-like light-emitting display device is disclosed that uses, on the front surface of the elastomer sheet, a light-transmissive artificial leather sheet provided with irregularities in a leather-like pattern.

### [Citation List]

### [Patent Literatures]

[PTL 1] Japanese Laid-Open Patent Publication No. 2013-177714
[PTL 2] Japanese Laid-Open Patent Publication No. 2014-173203

### [Summary of Invention]

### [Technical Problem]

It is an object of the present invention to provide a leather-like light-emitting display device having a leather-like appearance, concealing performance for internal structures, and light-emitting display performance with high visibility. The leather-like light-emitting display device presents a leather-like appearance with high concealing performance that makes internal structures such as fibers less likely to be seen through the surface, and can display characters, diagrams, patterns, and the like by light emission so as to appear on the surface of a leather-like colored resin layer with excellent visibility and high contrast when a light source is turned on.

### [Solution to Problem]

An aspect of the present invention relates to a leather-like light-emitting display device, including: a leather-like sheet that is a laminate of a colored resin layer forming an outer surface layer, and a fiber substrate; a light-emitting portion disposed below the leather-like sheet; and a light-blocking portion configured to partially limit transmission of light, and interposed between any layers from the colored resin layer to the light-emitting portion, wherein the leather-like light-emitting display device is configured to exhibit light-emitting display with a luminance Ya of 200 cd/m² or less in a non-light emitting region corresponding to the light-blocking portion and a luminance Yb of 100 to 2,000 cd/m² in a light-emitting region corresponding to a portion other than the light-blocking portion, both as measured from a surface of the colored resin layer, Yb/Ya being 2.0 or more. Here, a luminance refers to a luminosity (cd/m²) of light emission per unit area. With such a configuration, it is possible to provide a leather-like light-emitting display device having a leather-like appearance, concealing performance for internal structures, and light-emitting display performance with high visibility. The leather-like light-emitting display device presents a leather-like appearance that makes internal structures such as fibers less likely to be seen through the surface, and can display characters, diagrams, patterns, and the like by light emission so as to appear on the surface of a colored resin layer of a leather-like sheet with excellent visibility and high contrast when a light source is turned on.

In the leather-like light-emitting display device, it is preferable that, while the light-emitting portion is turned off, the light-emitting region has a lightness L* value of 5 or more and 15 or less, as measured from the surface of the colored resin layer under a condition using a D65 light source. When the lightness L* value of the light-emitting region is in such a range, the leather-like light-emitting display device provides clearer contrast when the light-emitting portion is turned on, and also can be easily adjusted so as to have concealing performance for concealing internal structures, and high visibility.

When the colored resin layer has an average value of light transmittance of 15% or more for the entire visible light range of a wavelength of 380 to 780 nm, and an average value of light transmittance of 50% or more for a range of a wavelength of 680 to 780 nm, the leather-like light-emitting display device provides clearer contrast in light-emitting display, and can be easily adjusted so as to have the concealing performance and high visibility. Here, the average values of the light transmittance are both arithmetic mean values.

It is preferable that the colored resin layer includes a polyurethane, and a first colorant dispersed in the polyurethane, and the first colorant has an average dispersed particle size of 400 nm or less, and it is also preferable that the first colorant is miscible (compatible) with the polyurethane at a molecular level, from the viewpoint of ease of obtaining a colored resin layer that maintains high light transmission even when colored in a dark color.

It is preferable that the light-blocking portion is a printed layer, from the viewpoint of ease of clearly forming a light-blocking portion that provides excellent contrast and has excellent light-blocking properties.

It is preferable that the light-blocking portion includes carbon black, from the viewpoint of ease of providing high contrast due to high light-blocking properties exhibited by the light-blocking portion.

It is preferable that the fiber substrate is a fiber structure including fibers having an average fiber diameter of 1.0 to 10.0 um, from the viewpoint of ease of providing higher contrast.

It is preferable that the light-emitting portion is a surface-emitting device having an emission intensity in a range from 500 to 40,000 cd/m², from the ease of adjusting the leather-like light-emitting display device so as to have the above-described luminance Ya and luminance Yb.

### [Advantageous Effects of Invention]

According to the present invention, it is possible to obtain a leather-like light-emitting display device having a leather-like appearance, concealing performance for internal structures, and light-emitting display performance with high visibility. The leather-like light-emitting display device presents a leather-like appearance with high concealing performance that makes internal structures such as fibers less likely to be seen through the surface, and can display characters, diagrams, patterns, and the like by light emission so as to appear on the surface of a colored resin layer of a leather-like sheet with excellent visibility and high contrast when a light source is turned on.

### [Brief Description of Drawings]

[FIG. 1] FIG. 1 is a partially enlarged schematic cross-sectional view of a leather-like light-emitting display device 100 according to an embodiment.
[FIG. 2] FIG. 2 shows schematic top views of the leather-like light-emitting display device 100 according to the embodiment.
[FIG. 3] FIG. 3 is a schematic top view of a light source module that is housed in a surface-emitting light source 50 according to the embodiment, and that includes a surface-mount substrate 53 having multiple LED devices 52 surface-mounted thereon.
[FIG. 4] FIG. 4 is a partially enlarged schematic cross-sectional view of a leather-like light-emitting display device 110 according to another embodiment.
[FIG. 5] FIG. 5 is a partially enlarged schematic cross-sectional view of a leather-like light-emitting display device 120 according to yet another embodiment.
[FIG. 6] FIG. 6 is a partially enlarged schematic cross-sectional view of a leather-like light-emitting display device 130 according to still another embodiment.
[FIG. 7] FIG. 7 shows spectra of light transmittance for a visible light range of a wavelength of 380 to 780 nm of colored resin sheets (colored resin layers) obtained in Example 5 and Comparative Example 6.

### [Description of Embodiment]

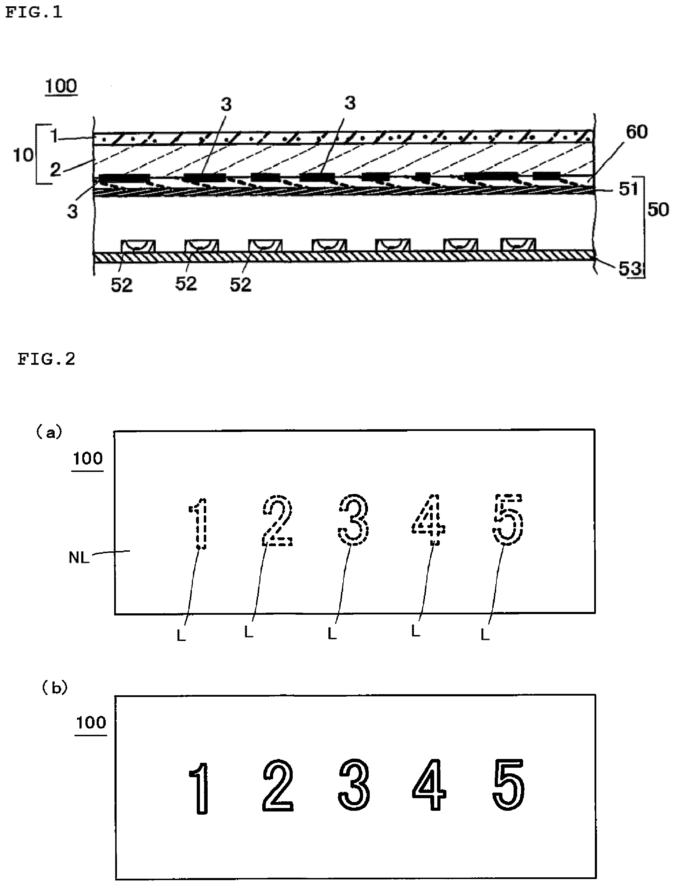

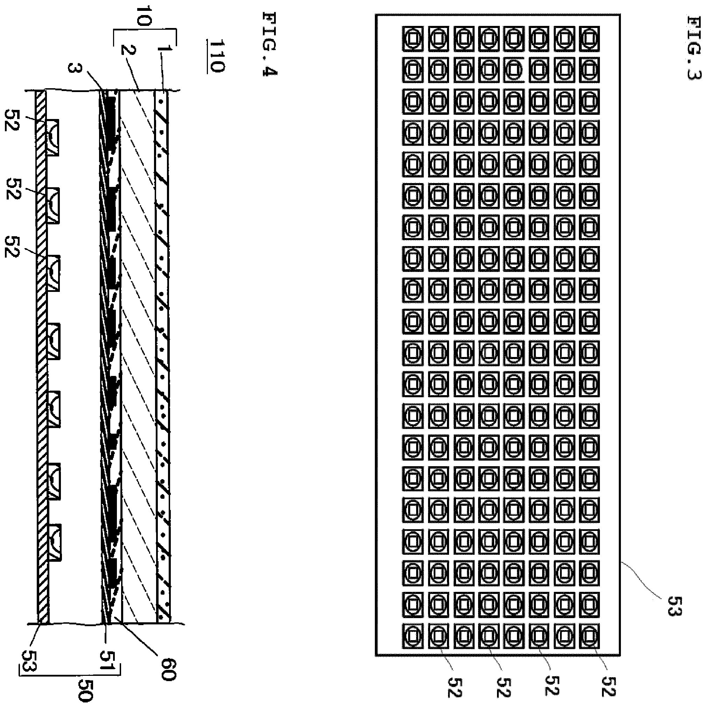

An embodiment of a leather-like light-emitting display device according to the present invention will be described in detail with reference to the drawings. FIG. 1 shows a partially enlarged schematic cross-sectional view of a leather-like light-emitting display device 100, which is a typical example of the leather-like light-emitting display device according to the present embodiment. FIG. 2 shows schematic top views of the leather-like light-emitting display device 100, with FIG. 2(a) showing the device when a light-emitting portion in turned off, and FIG. 2(b) showing the device when the light-emitting portion is turned on. FIG. 3 is a schematic top view of a light source module that includes a surface-mount substrate 53 housed in a surface-emitting light source 50 serving as a light-emitting portion of the embodiment, and that has multiple LED devices 52 surface-mounted thereon.

In FIG. 1, numeral 1 denotes a colored resin layer forming an outer surface layer, numeral 2 denotes a fiber substrate, and numeral 10 denotes a leather-like sheet that is a laminate of the colored resin layer 1 and the fiber substrate 2. Numeral 50 denotes a surface-emitting light source (light-emitting portion) that provides surface lighting with light emitted from the multiple LED devices 52. Numeral 3 denotes a light-blocking portion configured to partially limit light transmission, and interposed between any layers from the colored resin layer 1 to the surface-emitting light source 50.

The surface-emitting light source 50 includes a casing, which is not shown, a light source module constituted by a surface-mount substrate 53 that is housed in the casing, and that has multiple LED devices 52 surface-mounted thereon, and a light-transmissive light cover 51 that covers the light source module.

As the LED devices 52, it is possible to use, without any particular limitation, for example, a blue LED device including a blue LED chip, a white LED device configured to emit white light or incandescent-color light by combining a blue LED chip and a phosphor, a green LED device including only a green LED chip, a red LED device including only a red LED chip, a near-ultraviolet LED device configured to emit light by combining a near-ultraviolet LED chip and a phosphor, and a full-color LED device including LED chips that emit red, green, or blue light, and configured to change the emission colors by changing the magnitude of the current to be passed through each of the LED chips to change the intensity of light of each of the colors, and changing the mixing ratio of the three colors. Note that the light-emitting portion may be a light-emitting portion including, in place of the LED devices, HID lamps (High Intensity Discharge lamps), fluorescent lamps, halogen lamps, incandescent lamps, or the like as the light sources.

The light cover 51 is a light-transmissive molded body molded in a shape corresponding to the intended use. Preferably, the light cover 51 is formed so as to include, on a light-emitting surface thereof, grain shapes, inorganic particles such as silica particles, an organic pigment or an inorganic pigment serving as a color filter, thus diffusing light emitted from the multiple LED devices 52, which are point light sources, and causing the light to be surface-emitted with a uniform luminance.

Examples of the types of the transparent resin serving as a main component used for the light-transmissive molded body include, but are not particularly limited to, acrylic resins, methacrylic resins, ABS-based resins, polyolefin-based resins, polycarbonate-based resins, and silicone-based resins. Note that the light-transmissive molded body includes transparent, semi-transparent, and colored transparent molded bodies. The average value of light transmittance of the light-emitting surface of the light cover for the entire visible light range of a wavelength of 380 to 780 nm is preferably 5% or more, more preferably 50% or more, particularly preferably 85% or more, and quite particularly preferably 95% or more.

Referring to FIG. 3, the surface-emitting light source 50 includes multiple LED devices 52, and a surface-mount substrate 53 having the multiple LED devices 52 mounted thereon. The number of LED devices 52 to be mounted on the surface-mount substrate 53 is appropriately selected according to the emission intensities of the LED devices, and the luminance of the desired leather-like light-emitting display device such that the luminance can be adjust as described below. As a result of power being supplied to the LED devices 52, the surface-emitting light source 50 causes surface emission of the light-emitting surface of the light cover 51.

The surface-mount substrate 53 has, for example, a current control unit such as an LED driver (not shown) mounted thereon. As the LED driver, a known LED driver including a constant current circuit configured to control the current values supplied from the LED devices 52, a PWM control circuit configured to control the luminosity by pulse control, or the like can be used without any particular limitation. The type of such LED drivers is appropriately selected according to the luminance of the desired leather-like light-emitting display device.

There is no particular limitation on the emission intensity of the surface-emitting light source, as long as it is possible to realize a leather-like light-emitting display device described in detail below in which a non-light emitting region corresponding to the light-blocking portion exhibits a luminance Ya of 200 cd/m² or less, and a light-emitting region corresponding to a light-transmitting portion other than the light-blocking portion exhibits a luminance Yb of 100 to 2,000 cd/m², and Yb/Ya is 2.0 or more. Preferably, the emission intensity of the surface-emitting light source is in the range from, for example, 500 to 40,000 cd/m², from the viewpoint of ease of adjusting the luminance to the above-described luminance Ya and the luminance Yb. As long as the above-described luminance relationship can be established, the surface-emitting light source may also have the function of adjusting the luminance.

Referring to FIG. 1, the leather-like light-emitting display device 100 is formed by bonding a fiber substrate 2 of a leather-like sheet 10 to the light-emitting surface of the light cover 51 of the surface-emitting light source 50, with an adhesion layer 60 interposed between the fiber substrate 2 and the light-emitting surface. Also, a light-blocking portion 3 that partially limits transmission of light is interposed between layers from the colored resin layer 1 to the surface-emitting light source 50.

The light-blocking portion 3 is formed by printing the fiber substrate 2 with an ink including a pigment such as a black pigment, such that characters, diagrams, patterns, or the like corresponding to the light-emitting region are left white. The formation of the light-blocking portion is not limited to printing the fiber substrate in this manner. For example, the light-blocking portion may be formed such that a transparent resin sheet having the light-blocking portion printed thereon is bonded to the fiber substrate, or to the light-emitting surface of the light-emitting portion, as will be described below. The light-blocking portion may be directly printed on the light-emitting surface. Furthermore, the light-blocking portion may be formed not only by printing, but also by transferring a decal. It is particularly preferable to form the light-blocking portion by printing in that a light-blocking portion providing high contrast performance is likely to be formed clearly, and excellent productivity due to ease of design change can be achieved.

The printing method that can be used for printing the light-blocking portion includes screen printing, gravure printing, inkjet printing, and so forth. Among these, screen printing is preferable in that it allows the light-blocking portion to be stably formed at a relatively low cost, and therefore has excellent mass productivity for printing.

Examples of the ink that can be used for printing include a pigment ink including a pigment having high concealing performance, such as carbon black or titanium oxide, and a binder such as an acrylic resin, and a dye ink including a dark color dye. It is preferable that the light-blocking portion includes carbon black from the viewpoint of exhibiting high light-blocking properties due to a large dispersed particle size, and having excellent contrast performance.

The light-blocking portion formed in this manner is not particularly limited as long as a leather-like light-emitting display device exhibiting the luminance Ya and the luminance Yb as described above, but is preferably a film having an average value of light transmittance of preferably 0.05% or less, and more preferably 0.02% or less, for the entire visible light range of a wavelength of 380 to 780 nm. The thickness of the light-blocking portion is also not particularly limited, but is preferably about 5 to 80 µm, and more preferably about 20 to 50 µm.

The position of the light-blocking portion is not particularly limited as long as the light-blocking portion is formed so as to be interposed between any layers from the colored resin layer to the light-emitting portion. For example, FIG. 4 is a partially enlarged schematic cross-sectional view of a leather-like light-emitting display device 110 according to another embodiment. In the leather-like light-emitting display device 110, the light-blocking portion 3 is printed on the light-emitting surface of the light cover 51 that is a component of the surface-emitting light source 50.

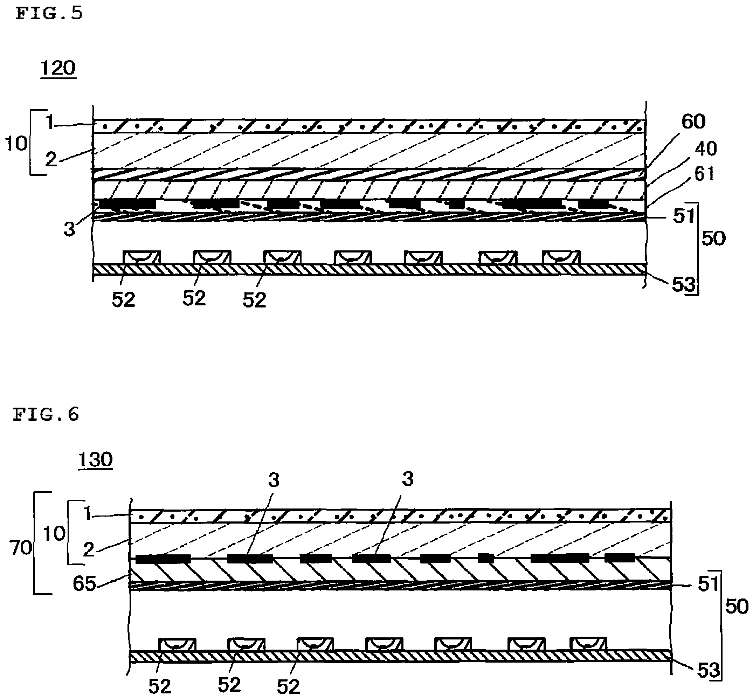

FIG. 5 is a partially enlarged schematic cross-sectional view of a leather-like light-emitting display device 120 according to yet another embodiment. In the leather-like light-emitting display device 120, the light-blocking portion 3 is formed by being printed on one side of a transparent resin layer (transparent resin sheet) 40. Also, the transparent resin layer 40 having the light-blocking portion 3 printed thereon is bonded to the fiber substrate 2 with the adhesion layer 60 interposed between the transparent resin layer 40 and the fiber substrate 2, and to the light-emitting surface of the light cover 51 with an adhesion layer 61 interposed between the transparent resin layer 40 and the light-emitting surface. The transparent resin layer 40 may have light diffusion properties.

FIG. 6 is a partially enlarged schematic cross-sectional view of a leather-like light-emitting display device 130 according to still another embodiment. The leather-like light-emitting display device 130 includes the same leather-like sheet 10 as that of the leather-like light-emitting display device 100. The leather-like sheet 10 includes a light-blocking portion 3 that is partially printed such that characters, diagrams, patterns, or the like corresponding to the light-emitting region on the fiber substrate 2 are left white. The leather-like light-emitting display device 130 was produced using such a leather-like sheet 10 by in-mold decorative molding using injection molding as described below.

With the surface resin layer 1 disposed facing a cavity surface of a mold, the leather-like sheet 10 having the light-blocking portion 3 printed thereon is housed in an injection molding mold. Then, into the injection molding mold that has been clamped, a resin melt of a light-transmissive resin is injected, and cooled, to mold a light-transmissive resin molded body laminated and integrated with the leather-like sheet 10 having the light-blocking portion 3 formed thereon. In this manner, a light-transmissive leather-like cover 70 in which the leather-like sheet 10 including the light-blocking portion 3 is laminated and integrated with a transparent resin layer (light-transmissive resin molded body) 65 as shown in FIG. 6 is formed. By fixing such a light-transmissive leather-like cover 70 to the surface of the light cover 51 that is a component of the surface-emitting light source 50 by bonding or using clamps, screws, or the like, a leather-like light-emitting display device 130 can be obtained. Such a transparent resin layer 65 may also have light diffusion properties.

FIG. 2 shows schematic top views of the leather-like light-emitting display device 100. FIG. 2(a) is an image of the device when the surface-emitting light source 50 is turned off, and FIG. 2(b) is an image of the device when the surface-emitting light source 50 is turned on. Referring to FIG. 2, the leather-like light-emitting display device 100 is composed of a light-emitting region L that is a non-printed region including outlines of numeric characters 1 to 5, and a non-light emitting region NL corresponding to the light-blocking portion 3 that is printed such that the outlines of the numeric characters 1 to 5 are left white.

In the leather-like light-emitting display device 100, internal structures such as fibers, and the characters, diagrams, or patterns formed by the light-emitting region L are less visible from the surface when the surface-emitting light source 50 is turned off, as shown in FIG. 2(a). On the other hand, when the surface-emitting light source 50 is turned on, the light-blocking portion 3 partially limits transmission of light, so that light is transmitted only through the light-emitting region L corresponding to the portions other than the light-blocking portion 3, causing the numeric characters 1 to 5 to appear on the surface of the colored resin layer 1 with high contrast, as shown in FIG. 2(b).

Also, the leather-like light-emitting display device 100 is a leather-like light-emitting display device that exhibits light-emitting display, and that is adjusted such that the non-light emitting region NL corresponding to the light-blocking portion 3 of the leather-like light-emitting display device exhibits a luminance Ya of 200 cd/m² or less , and the light-emitting region L corresponding to the portions other than the light-blocking portion 3 exhibits a luminance Yb of 100 to 2,000 cd/m², and Yb/Ya of 2.0 or more. By adjusting the luminance in this way, it is possible to obtain a leather-like light-emitting display device having a leather-like appearance and high visibility. The leather-like light-emitting display device presents a leather-like appearance with high concealing performance that makes internal structures such as fibers less likely to be seen through the surface, and can display characters, diagrams, patterns, and the like by light emission so as to appear on the surface of the colored resin layer of the leather-like sheet, with excellent visibility and high contrast when the light source is turned on.

Such a leather-like light-emitting display device is adjusted such that the luminance Ya is 200 cd/m² or less, the luminance Yb is 100 to 2,000 cd/m², and Yb/Ya of is 2.0 or more, preferably adjusted such that the luminance Ya is 150 cd/m² or less, the luminance Yb is 200 to 1500 cd/m², and Yb/Ya is 2.5 or more, and more preferably adjusted such that the luminance Ya is 120 cd/m² or less, the luminance Yb is 140 to 450 cd/m², and Yb/Ya is 3.0 or more.

If the luminance Ya of the non-light emitting region is greater than 200 cd/m², the internal structures are likely to be seen through the surface when not illuminated.

If the luminance Yb of the light-emitting region is less than 100 cd/m², the luminance of the light-emitting region is excessively reduced, so that the visibility of characters, diagrams, or patterns, in particular, the visibility of fine patterns or the like is reduced, resulting in a reduction in the visibility when the environment has high illuminance.

If the luminance Yb of the light-emitting region exceeds 2,000 cd/m², fine patterns or the like become blurred and less likely to be visible due to the excessively high luminance.

If Yb/Ya is less than 2.0, the luminance Yb of the light-emitting region is too low as compared with the luminance Ya of the non-light emitting region, so that the contrast of the light-emitting region relative to the non-light emitting region is reduced.

It is preferable that, in the leather-like light-emitting display device, the light-emitting region has a lightness L* value of 5 or more and 15 or less, as measured from the surface of the colored resin layer under a condition using a D65 light source while the light-emitting portion is turned off. If the lightness L* value of the light-emitting region is in such a range, the contrast becomes clearer when illuminated, and the device can be more easily adjusted such that light-emitting display having excellent concealing performance of concealing internal structures and excellent visibility can be achieved.

The leather-like sheet used in the present embodiment includes a fiber substrate, and a colored resin layer forming an outer surface layer stacked on the fiber substrate. The colored resin layer is a layer forming an outer surface layer in which a colorant is dispersed in a light-transmissive resin, and the layer allows light to be transmitted therethrough when illuminated, and is adjusted so as to conceal the internal structures from the surface of the leather-like light-emitting display device.

The resin serving as a main component of the colored resin layer is not particularly limited as long as a light-transmissive resin having sufficient light transmission is used, and various resins having an average value of light transmittance of preferably 60% or more, more preferably 70% or more, for the entire visible light range of a wavelength of 380 to 780 nm are preferably used. As specific examples of such a light-transmissive resin, those conventionally used for producing grain-finished leather-like sheets, such as a polyurethane, an acrylic elastic body, a silicone-based elastic body, a polyamide-based elastic body, a polyester-based elastic body, a polystyrene-based elastic body, and a polyolefin-based elastic body are preferably used. Among these, a polyurethane is particularly preferred from the viewpoint of ease of obtaining a leather-like sheet having well-balanced light transmission and leather-like tactile impression.

Specific examples of the polyurethane include a polycarbonate-based polyurethane, a polyether-based polyurethane, a polyester-based polyurethane, a polycarbonate/polyether-based polyurethane, and a polyester/polyether-based polyurethane. Among these, a polycarbonate-based polyurethane is particularly preferred because of the excellent durability and heat resistance.

As the coloring pigment dispersed in the light-transmissive resin, it is preferable to use a pigment or dye having excellent dispersibility, and it is particularly preferable to use a pigment or dye that increases the transmission of light in the range of 680 to 780 nm. Specific examples of such a pigment include a reactive special pigment, such as Vivitint and Reactint manufactured by Milliken & Company, that include a polymer segment such as a polyol bound to a chromophore, and have a reactive functional group at the terminal of the segment; dispersing-type perylene black and aniline black; organic pigments such as Pigment Yellow 73 and Pigment Red 5; polymerizable dyes in which a reactive polymerizable group is incorporated; disperse dyes; and basic dyes. Among these, reactive special pigments, such as Vivitint and Reactint, that include a polymer segment such as a polyol bound to a chromophore are particularly preferred.

Note that the polymer segment in a reactive special pigment contributes to the enhancement of compatibility in the colored resin layer. When the resin serving as a main component of the colored resin layer is a polyurethane, and the polymer segment is a polyol, the dispersibility in the colored resin layer is particularly improved because a polymer polyol unit that is the soft segment of the polyurethane and the polymer segment that is a polyol exhibit favorable compatibility. By reacting the reactive polymerizable group of the reactive special pigment with the molecules of the resin forming the colored resin layer, the dispersibility of the coloring pigment can be further enhanced.

In the colored resin layer, usually, increased light transmission is likely to result in a reduced degree of darkness, and an increased degree of darkness is likely to result in reduced light transmission. In the present embodiment, the type and the dispersed state of the coloring pigment, and the surface emission intensity of the surface-emitting light source are adjusted so as provide a leather-like appearance having high concealing performance that makes the internal structures such as fibers less likely to be seen through the surface of the leather-like light-emitting display device, while enabling sufficient transmission of emitted light when the light-emitting portion is turned on.

The colorant has an average dispersed particle size of preferably 400 nm or less, more preferably 300 nm or less, and it is particularly preferable that the colorant is miscible (compatible) in the colored resin sheet at a molecular level such that the shapes of the outlines of the colorant particles cannot be clearly identified. When the average dispersed particle size of the colorant is too large, light with a long wavelength is likely to be scattered or reflected by the colorant particles, so that the average value of visible light transmittance for a red range of a wavelength of 680 to 780 nm described below is less likely to be kept at 50% or more.

It is preferable that the colored resin layer or the colored resin sheet for forming the colored resin layer has a dark color or a deep color having a lightness L* value of 5 or more and 15 or less, or a medium-dark color having a lightness L* value greater than 15 and less than or equal to 35 in the light-emitting region, because the contrast when illuminated on becomes clearer, and adjustment can be easily made such that light-emitting display having better concealing performance and visibility is likely to be obtained.

In the case of using a colored resin sheet having a dark color with a lightness L* value of 5 or more and 15 or less, or a colored resin sheet having a medium-dark color with a lightness L* value greater than 15 and less than or equal to 35, the average value of the visible light transmittance for a red region of a wavelength of 680 to 780 nm is preferably 50% or more, and more preferably 55 to 65%. When the colored resin sheet has an average value of the visible light transmittance of 50% or more for a red region of a wavelength of 680 to 780 nm, it is possible to allow transmission of a large amount of light in the red region of a wavelength of 680 to 780 nm, which is less likely to brighten the emission color, thus maintaining a high average value of light transmittance for the visible light range as a whole.

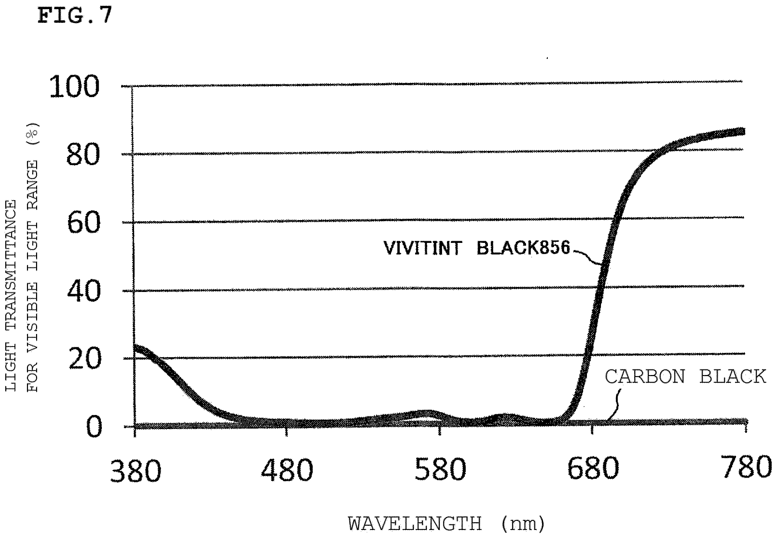

In the case of using a colored resin sheet having a dark color with a lightness L* value of 5 or more and 15 or less, the average value of light transmittance for the entire visible light range of a wavelength of 380 to 780 nm is 15% or more, and more preferably 15 to 26%. For example, referring to FIG. 7, the colored resin sheet used in Example 3 described below, in which 10 mass% of VIVITINT BLACK856 is mixed, is a colored resin sheet having a deep dark black color with a lightness L* value of 7.9, and an average value of light transmittance of 20.5% for the entire visible light range of a wavelength of 380 to 780 nm. On the other hand, the colored resin sheet, shown in FIG. 7, used in Comparative Example 3 described below, in which 2.0 mass% of carbon black is mixed, is a colored resin sheet having a dark color with a lightness L* value of 10.0, and an average value of light transmittance of 4.8% for the entire visible light range of a wavelength of 380 to 780 nm.

In the case of a medium-dark color with a lightness L* value greater than 15 and less than or equal to 35, the average value of light transmittance for the entire visible light range of a wavelength of 380 to 780 nm is preferably 25% or more, and more preferably 25 to 35%. For example, the colored resin sheet in which 5 mass% of dispersing-type perylene black is mixed, which was used in Example 4 described below is a colored resin sheet having a medium-dark color with a lightness L* value of 23.7, and an average value of light transmittance of 25.2% for the entire visible light range of a wavelength of 380 to 780 nm.

The thickness of the colored resin layer or the colored resin sheet for forming the colored resin layer, and the content ratio of the colorant are adjusted according to the lightness L* value of the surface of the desired colored resin layer. Examples of the thickness of the colored resin layer and the content ratio of the colorant include a combination of a colored resin layer thickness of 30 to 90 um and a colorant content ratio of 1 to 20 parts by mass per 100 parts by mass of the resin. For example, it is preferable to add about 7.5 to 15.0 parts by mass of a black pigment per 100 parts by mass of the resin in the case of obtaining a black color, and it is preferable to add about 1.0 to 5.0 parts by mass of a black pigment and about 2.5 to 7.5 parts by mass of a red pigment, per 100 parts by mass of the resin, in the case of obtaining a dark brown color. When the mixing proportion of the pigment is too high, the light transmission is reduced.

The colored resin layer may have a monolayer structure made of a resin composition having a uniform formulation, or may have a stacked structure composed of a plurality of layers made of resin compositions having formulations different from each other.

The fiber substrate is not particularly limited, but is preferably a non-woven fabric. Due to the randomness in the directions of entangled fibers of a non-woven fabric, the fiber patterns are less likely to be visually recognized when light is transmitted through the non-woven fabric, and therefore the non-woven fabric has excellent luminance uniformity in light-emitting display. On the other hand, in the case where the fibers of the fiber substrate are oriented in a specific direction such as those of a knitted fabric and a woven fabric, when light is transmitted through the fiber substrate, the fiber structures tend to be projected by the transmitted light, thus reducing the luminance uniformity in light-emitting display.

As the resin for forming the fibers of the fiber substrate, a thermoplastic resin having light transmission is preferably used. Specific examples of such a thermoplastic resin include thermoplastic resins having fiber-forming properties, including, for example, polyester resins such as polyethylene terephthalate (PET) or modified polyester resins, such as a modified PET, obtained by copolymerization thereof with a trace amount of a monomer unit; polyamide resins such as polyamide 66; various acrylic resins; and olefin resins such as polyethylene and polypropylene. These may be used alone or in combination of two or more thereof.

The fiber configuration, including, for example, the fiber diameter, the cross-sectional shape, and the fiber length of the fibers forming the fiber substrate can be selected as appropriate. As the fiber configuration, a non-woven fabric made of fibers having an average fiber diameter of 1.0 to 10.0 µm, preferably 1.5 to 9.0 um, and more preferably 2.0 to 8.0 µm is preferred in that such a non-woven fabric has excellent suppleness and can be densified to have a reduced porosity, thus enhancing the light transmission. When the average fiber diameter of the non-woven fabric exceeds 10.0 um, shadows of the entangled fibers are likely to be projected by the transmitted light, so that the luminance uniformity in light-transmitting display may be reduced. Note that the average fiber diameter can be calculated by taking a scanning electron microscope (SEM) photograph of a cross section of a leather-like sheet at a magnification of 3000X, measuring the fiber diameters of 10 randomly selected fiber cross sections, and determining the average value of the fiber diameters.

Various additives, specifically, for example, a stain inhibitor, a heat-resistant agent, a flame retardant, a lubricant, an antifouling agent, a fluorescent brightener, a matting agent, a gloss improver, an antistatic agent, a fragrance, a deodorant, a catalyst, an antimicrobial, a tick repellent, and inorganic particles may be mixed as necessary in the resin used for production of the fiber substrate, as long as the objects and effects of the present invention are not impaired.

Note that the resin used for producing the non-woven fabric is preferably in the form of uncolored or white fibers containing substantially no colorant that colors the fibers, from the viewpoint of ease of obtaining a leather-like sheet having high light transmission. Here, the uncolored or white fibers mean fibers in which a colorant such as a coloring pigment or a dye is not mixed with a raw material prior to spinning.

It is preferable that the fiber substrate contains, in internal voids thereof, an elastic polymer, preferably a light-transmissive, uncolored elastic polymer. Specific examples of such an elastic polymer include a polyurethane-based elastic body, an acrylic elastic body, a polyamide-based elastic body, a polyester-based elastic body, a polystyrene-based elastic body, and a polyolefin-based elastic body. Among these, a polyurethane-based elastic body and an acrylic elastic body, in particular, a combination of a polyurethane-based elastic body and an acrylic elastic body is preferred because of the well-balanced light transmission and mechanical properties. In addition, the elastic polymer is preferably a non-foam in order to maintain high light transmission.

When the fiber substrate is an entangled non-woven fabric of ultrafine fibers made of island component obtained by removing a sea component from an entangled sheet of island-in-the-sea composite fibers, it is preferable to apply the elastic polymer also into voids in a fiber bundle formed as a result of removing the sea component, because the refractive index difference is reduced by replacing an interface between the ultrafine fibers and the air with an interface between the ultrafine fibers and the elastic polymer, thus making it possible to further enhance the light transmission.

When the fiber substrate contains an elastic polymer, the content proportion of the elastic polymer in the fiber substrate is preferably 1 to 50 mass%, and more preferably 5 to 30 mass%.

When the fiber substrate contains the elastic polymer, the porosity in the fiber substrate is preferably 70 vol% or less, more preferably 60 vol% or less, particularly preferably 50 vol% or less, because high translucency is provided.

The thickness of the fiber substrate is preferably 0.1 to 1.0 mm, and more preferably 0.2 to 0.6 mm, from the viewpoint of ease of obtaining a leather-like sheet that maintains high light transmission.

The leather-like sheet can be produced, for example, in the following manner. First, a colored resin sheet serving as a colored resin layer is formed on a support substrate such as release paper. Thereafter, an adhesion layer is formed on the surface of the colored resin sheet, then the adhesion layer is attached to a fiber substrate, and the whole was pressed as necessary so as to be bonded together. Then, the release paper was released from the colored resin layer, thus obtaining a leather-like sheet. As an adhesive for forming the adhesion layer, it is preferable to use a two-liquid curable polyurethane resin adhesive, a hot-melt polyurethane resin adhesive, and the like that have been conventionally used as adhesives in the production of leather-like sheets. The thickness of the adhesion layer is not particularly limited, but is preferably 10 to 300 µm, for example. The amount of the adhesive is not limited, but is, for example, preferably an amount that results in a basis weight after bonding of about 50 to 100 g/m².

The thickness of the leather-like sheet obtained in this manner is not particularly limited, but is, for example, preferably about 0.02 to 10 mm, and more preferably about 0.05 to 5 mm, from the viewpoint of sufficiently maintaining the light transmission. The apparent density of the leather-like sheet is preferably 0.03 to 1.5 g/cm³, and more preferably 0.06 to 1.2 g/cm³.

The leather-like sheet has an average value of light transmittance of preferably 20 or more, more preferably 2 to 20%, and particularly preferably 2 to 10%, for the entire visible light range of a wavelength of 380 to 780 nm. When the average value of light transmittance for the entire visible light range of a wavelength of 380 to 780 nm is less than 2%, there is a tendency that characters, diagrams, or patterns are less likely to be clearly displayed with light on the surface of the colored resin layer due to low light transmission.

The surface of the leather-like sheet has a lightness L* value in a L*a*b*color system of preferably 40 or less, and more preferably 25 or less.

The leather-like sheet according to the present embodiment has an average value of light transmittance of preferably 5% or more, and more preferably 7 to 15%, for a red region of a wavelength of 680 to 780 nm. When the average value of light transmittance for a red region of a wavelength of 680 to 780 nm of the leather-like sheet is 5% or more, the leather-like sheet transmits therethrough a large amount of light in a red region that is less likely to brighten the emission color, and thus can easily maintain light transmission such that the average value of light transmittance for the entire visible light range of a wavelength of 380 to 780 nm is, for example, 2% or more, even if the leather-like sheet has a dark color with a surface lightness L* value of 15 or less, or a medium-dark color with a surface lightness L* value of greater than 15 and less than or equal to 35.

It is particularly preferable that the surface of the leather-like sheet has a lightness L* value of preferably 15 or less, and more preferably 15 or less and 5 or more, and that the leather-like sheet has an average value of light transmittance of 2% or more for the entire visible light range of a wavelength of 380 to 780 nm. Such a leather-like sheet is preferred in that, in a dark color, the leather-like sheet is particularly well-balanced in concealing performance and light transmission that renders light transmitted therethrough clear.

Such a leather-like light-emitting display device is preferably used as a light-emitting display device for use in a home electrical appliance, a lighting device, and office automation equipment, as well as an instrument panel or the like of a vehicle, an aircraft, and a vessel. In particular, the leather-like light-emitting display device is preferably used as a light-emitting display device having a high-quality appearance provided by leather-like visual feel and texture, and capable of realizing versatility in designs including the surroundings of the device.

### [Examples]

Hereinafter, the present invention will be described in further detail by way of examples. It should be appreciated that the scope of the invention is by no means limited to the examples.

First, the methods for evaluating leather-like sheets produced in the manner described below will be summarized below.

### (Average dispersed particle size and dispersibility of colorant)

Each leather-like sheet was embedded in an epoxy resin. Then, the colored resin sheet of the leather-like sheet embedded in the epoxy resin was sliced in the cross-sectional direction using an ultramicrotome, to produce a test piece. Then, the test piece was imaged using a transmission electron microscope ("H-800NA model" (magnification 10,000X to 100,000X) manufactured by Hitachi, Ltd.), and the average particle size of the colorant particles located in a field of view of 10 µm square was calculated. As for the average particle size, with the distance of the longest portion of each particle defined as a particle size, the particle sizes of the particles within a field of view were arithmetically averaged to determine an average particle size. The average particle sizes obtained at 10 locations were arithmetically averaged to determine an average dispersed particle size of the colorant. A colorant that was dissolved and the outlines were not identifiable was evaluated as "A", a colorant having an average dispersed particle size of less than 400 nm was evaluated as "B", and a colorant having an average dispersed particle size of 400 nm or more was evaluated as "C".

### (Measurement of light transmittance of colored resin sheet)

The light transmittance for a wavelength range of 380 to 780 nm of a film of the colored resin sheet released from the release paper was measured using a spectrophotometer (U-3010 Spectrophotometer manufactured by HITACHI). Then, the arithmetic mean value of light transmittance for the entire visible light range of a wavelength range of 380 to 780 nm, and the arithmetic mean value of light transmittance for the entire red region of 680 to 780 nm were determined. As examples, FIG. 7 shows spectra showing light transmittances for a visible light range of a wavelength of 380 to 780 of the colored sheets obtained in Example 3 and Comparative Example 3.

### (Measurement of light transmittance of leather-like sheet)

The light transmittance for a wavelength range of 380 to 780 nm of each leather-like sheet was measured using a spectrophotometer (U-3010 Spectrophotometer manufactured by HITACHI). Then, the arithmetic mean value of light transmittance for the entire visible light range of a wavelength range of 380 to 780 nm, and the arithmetic mean value of light transmittance for the entire red range of 680 to 780 nm were determined.

### (Lightness L* value)

The chromaticity of the surface of each colored resin sheet or the surface of the colored resin layer of each leather-like sheet was measured using a spectrocolorimeter (CM-3610d, manufactured by KONICA MINOLTA, INC., a D65 light source). Specifically, a standard whiteboard (an aluminum oxide board) was disposed on a side opposite to the surface of the colored resin sheet or the leather-like sheet, which was then set in the spectrocolorimeter and subjected to colorimetric measurement. From the colorimetric values, a lightness L* value in a L*a*b*color system was determined.

### (Apparent density of leather-like sheet)

The thickness (mm) and the basis weight (g/cm²) were measured in accordance with JIS L 1913, and the apparent density (g/cm³) was calculated from the measured values.

### (Average fiber diameter of fibers forming fiber substrate of leather-like sheet)

The average fiber diameter was determined by taking a scanning electron microscope (SEM) photograph of a cross section of the leather-like sheet in the thickness direction at a magnification of 3000X, and measuring the fiber diameters of 10 randomly selected fiber cross sections. Note that the diameter of a circumscribed circle of each of the selected fiber cross sections was used as the fiber diameter of the fiber. The average value of the obtained 10 fiber diameters was calculated as the average fiber diameter.

### (Porosity of fiber substrate of leather-like sheet)

A scanning electron microscope (SEM) photograph of a cross section of the leather-like sheet in the thickness direction was taken at a magnification of 300X, and the true thickness in the thickness direction was measured. From the basis weight of the fiber substrate and the density of the raw material used for the substrate, the porosity of the fiber substrate was calculated by the following equation: Porosity of fiber substrate (vol%) = (1 - (basis weight / density of a raw material) / (thickness / true thickness)) × 100

### [Example 1]

### (Production of leather-like sheet)

A water-soluble thermoplastic polyvinyl alcohol resin was use as a sea component, and an isophthalic acid-modified PET having a degree of modification of 6 mol% was used as an island component. Using a composite melt-spinning spinneret having a number of islands per one fiber of 25 and at a sea component/island component ratio of 25/75 (mass ratio), island-in-the-sea filaments were discharged from the spinneret at 260°C. Then, the ejector pressure was adjusted such that the spinning rate was 3700 m/min, and island-in-the-sea composite filaments having an average fineness of 2.1 dtex were collected on a net. Then, the island-in-the-sea composite filaments collected on the net were separated from the net by lightly pressing the filaments with a metal roll having a surface temperature of 42°C, while suppressing fuzzing on the surface. Then, the sheet released from the net was subjected to hot pressing by being passed between a grid-patterned metal roll having a surface temperature of 75°C and a back roll, thus obtaining a filament web having a basis weight of 31 g/m² and in which the ultrafine fibers on the surface were temporarily fused.

Then, the obtained filament web was laid in eight layers through cross lapping, and an oil solution for preventing the needles from breaking was sprayed thereto. Then, the web was needle punched at a punching density of 3300 punch/cm² alternately from both sides at a punching depth of 8.3 mm using 6-barb needles with a distance of 3.2 mm from the needle tip to the barb, thus obtaining an entangled filament web having a basis weight of 320 g/m².

Then, the filament web was heat-shrunk by being immersed in hot water for 14 seconds at 70°C at a take-up line speed of 10 m/min, thus obtaining a densified entangled web.

Next, the densified entangled web was impregnated with a polyurethane in the following manner. The densified entangled web was impregnated with a polyurethane emulsion (solid content concentration: 30%) composed mainly of a polycarbonate/ether-based polyurethane. Then, the entangled web was dried in a drying furnace at 150°C. The thus obtained polyurethane-impregnated entangled web was repeatedly subjected to dip-nipping in hot water at 95°C, to remove the modified PVA by dissolution, thus obtaining a non-woven fabric of ultrafine fibers in which fiber bundles each including 25 ultrafine filaments having an average fineness of 0.1 dtex were three-dimensionally entangled. Then, the non-woven fabric was sliced and buffed, thereby being conditioned into a non-woven fabric substrate of ultrafine fibers having an apparent density of 0.50 g/cm³, a thickness of 0.35 mm, and an average fiber diameter of 3.0 µm.

Then, the non-woven fabric substrate was impregnated with an acrylic elastic body emulsion (RYUDYE-W BINDER 11KS-EN, solid content: 30 mass%, manufactured by DIC Corporation) at a pick-up rate of 100%. Then, the substrate was dried for 10 minutes using a dryer at 100°C, thus obtaining a fiber substrate. The ratio of the effective components of the components in the fiber substrate, as calculated from the pick-up rate, was a ratio of ultrafine fibers/polyurethane/acrylic elastic body = 90/10/20 (mass ratio). The porosity of the fiber substrate was 44%.

Meanwhile, a black pigment (VIVITINT BLACK856 manufactured by Milliken & Company) was dispersed in a 30 mass% polyurethane DMF solution containing a non-yellowing polycarbonate-based polyurethane, thus preparing a resin solution for forming a colored resin layer. Here, 7.5 mass% of the black pigment relative to the solid content of the non-yellowing polycarbonate-based polyurethane was mixed in the resin solution. The prepared resin solution was applied onto release paper, and thereafter dried for 2 minutes at 120°C, thus forming a black colored resin sheet having a thickness of 60 µm. The obtained colored resin sheet was released from the release paper.

Next, a resin solution for forming an adhesion layer was applied onto a surface of the colored resin sheet formed on the release paper, and thereafter dried for 2 minutes at 120°C, thus forming an adhesion layer having a thickness of 50 um. The resin solution for forming the adhesion layer was a 30 mass% DMF solution of a polycarbonate-based polyurethane.

The thus formed adhesion layer on the release paper was placed in contact with one surface of the fiber substrate, and pressure-bonded thereto using a heated roll whose surface temperature was set at 75°C. Then, the whole was aged for 3 days at 50°C, and thereafter the release paper was released, thus obtaining a leather-like sheet including a black colored resin layer. The thus obtained leather-like sheet had a thickness of 0.31 mm, an apparent density of 1.07 g/cm³, and a basis weight of 333 g/m².

### (Production of leather-like light-emitting display device)

Using the obtained leather-like sheet, a leather-like light-emitting display device was produced and evaluated in the following manner.

A square area measuring 100 mm by 100 mm on one surface of the fiber substrate of the obtained leather-like sheet was printed by screen printing with a black ink using a screen plate such that numeric characters 1 to 9 with a 40 pt (14.11 mm) font size serving as a light-transmitting portion were left white, thus forming a light-blocking portion. Note that the formed light-blocking portion had a film thickness of about 20 µm.

The leather-like sheet having the light-blocking portion formed in a square area measuring 100 mm by 100 mm was set in a mold of an injection molding machine, and a transparent polycarbonate resin was injection-molded in a thickness of 1 mm on a surface located on the same side as the light-blocking portion, to obtain a light-transmissive leather-like cover including the light-blocking portion.

Meanwhile, a surface-emitting light source having a square light-emitting surface measuring 100 mm by 100 mm, and housing multiple white LED devices therein was prepared as a surface-emitting light source. Note that the surface-emitting light source is provided with a luminance adjustment range of 0 to 40,000 cd/m² for the light-emitting surface.

Then, the light-transmissive leather-like cover was fixed to the surface-emitting light source at four corners using screws such that the light-transmissive leather-like cover was in close contact with the light-emitting surface of the surface-emitting light source. In this manner, a leather-like light-emitting display device was produced. Then, the leather-like light-emitting display device was evaluated according to the following evaluation methods.

### (Lightness L* value of light-emitting region)

The chromaticity of the light-emitting region was measured using a spectrocolorimeter (CM-25cG manufactured by KONICA MINOLTA, INC.) from the surface of the colored resin sheet of the leather-like light-emitting display device. Specifically, while the surface-emitting light source was turned off, the surface of the colored resin sheet corresponding to the light-emitting display portion is subjected to colorimetric measurement, to determine a lightness L* value as measured using a D65 light source.

### (Measurement of luminance)

The light-emitting surface of the surface-emitting light source of the leather-like light-emitting display device was caused to emit light. By turning the surface-emitting light source on, the numeric characters printed so as to be left white were displayed by light emission so as to appear in the light-emitting region that was the light-transmitting portion corresponding to the portions of the surface of the leather-like light-emitting display device other than the light-blocking portion. While the numeric characters were displayed by light emission, the luminance of the light-emitting surface of the light-emitting display device was measured in a dark room from a distance of 70 cm, perpendicularly to the light-emitting surface, using a spectroradiometer (2D spectroradiometer SR-5000 HS manufactured by TOPCON TECHNOHOUSE CORPORATION). Then, the average values of the luminance data for each pixel of the non-light emitting region corresponding to the light-blocking portion, and the light-emitting region corresponding to the light-transmitting portion were calculated as a luminance Ya and a luminance Yb, respectively.

### (Evaluation of leather-like light-emitting display device)

The visibility was evaluated by 10 automobile users based on the following criteria. Then, the evaluation was determined by a majority vote.
A: When the surface-emitting light source was turned on, the numeric characters in the light-emitting region were displayed with high contrast relative to the non-light emitting region, and all the numeric characters were clearly recognized at a glance. When the light source was turned off, the internal structures were not seen through the surface.
B: When the surface-emitting light source was turned on, the numeric characters in the light-emitting region were displayed with high contrast relative to the non-light emitting region, and all the numeric characters were clearly recognized at a glance. However, when the light source was turned off, the internal structures were seen through the surface.
C: When the surface-emitting light source was turned on, the numeric characters in the light-emitting region were displayed with low contrast relative to the non-light emitting region, and the numeric characters seemed difficult to be clearly recognized at a glance. On the other hand, when the light source was turned off, the internal structures were not seen through the surface.
D: When the surface-emitting light source was turned on, the numeric characters in the light-emitting region were displayed with high contrast relative to the non-light emitting region. However, due to an excessively high luminance, the details seemed difficult to be recognized. When the light source was turned off, the internal structures were seen through the surface.

The results are shown in Table 1 below.

**[Table 1]**

| Example No. | | | 1 | 2 | 3 | 4 | 5 | Com. Ex. 1 | Com. Ex. 2 | Com. Ex. 3 | Com. Ex. 4 | Com. Ex. 5 |
|---|---|---|---|---|---|---|---|---|---|---|---|---|
| Colorant | Vivitint BL856 (parts) | | 7.5 | 7.5 | 10 | - | 7.5 | 7.5 | 7.5 | - | 7.5 | 7.5 |
| | Carbon black (parts) | | - | - | - | - | - | - | - | 2.0 | - | - |
| | Perylene black (parts) | | - | - | - | 5 | - | - | - | | - | - |
| | Average dispersed particle size (nm) | | Invisible | Invisible | Invisible | 260 | Invisible | Invisible | Invisible | 492 | Invisible | Invisible |
| | Dispersibility | | A | A | A | B | A | A | A | C | A | A |
| Colored resin sheet | Film thickness (µm) | | 60 | 60 | 60 | 60 | 60 | 60 | 60 | 60 | 60 | 60 |
| | Average transmittance (%) | 380-780 nm | 25.2 | 25.2 | 20.5 | 25.2 | 25.2 | 25.2 | 25.2 | 4.8 | 25.2 | 25.2 |
| | | 680-780 nm | 64.1 | 64.1 | 60.8 | 59.0 | 64.1 | 64.1 | 64.1 | 5.2 | 64.1 | 64.1 |
| | L* value | | 14.3 | 14.3 | 7.9 | 23.7 | 14.3 | 14.3 | 14.3 | 10.0 | 14.3 | 14.3 |
| Fiber substrate | Fibers | | PET | | | | | PET | | | - | - |
| | Average fiber diameter (µm) | | 3.0 | | | | | 13.6 | 13.6 | 3.0 | - | - |
| | Configuration | | Non-woven fabric | | | | | Knitted fabric | Non-woven fabric | | - | - |
| | Color | | White | | | | | White | | | - | - |
| | Ultrafine fibers/polyurethane/acrylic elastic body (mass ratio) | | 90/10/20 | 90/10/20 | 90/10/20 | 90/10/20 | 90/10/20 | - | 90/10/20 | 90/10/20 | - | - |
| | Porosity (3) | | 44 | 44 | 44 | 44 | 44 | - | 44 | 65 | - | - |
| Leather-like sheet | Average transmittance (3) | 380-780 nm | 3.8 | 3.8 | 2.6 | 2.4 | 3.8 | 4.5 | 3.8 | 0.3 | 25.2 | 25.2 |
| | | 680-780 nm | 9.3 | 9.3 | 9.0 | 8.6 | 9.3 | 10.8 | 9.3 | 0.6 | 64.1 | 64.1 |
| | L* value | | 10.9 | 10.9 | 7.7 | 12.3 | 10.9 | 11.4 | 10.9 | 26.7 | 14.3 | 14.3 |
| Surface-emitting light source | Luminance of light-emitting surface (cd/m²) | | 10000 | 2500 | 10000 | 10000 | 40000 | 10000 | 10000 | 10000 | 10000 | 2500 |
| Leather-like light-emitting display device | Luminance (cd/m²) | Non-light emitting region (Ya) | 116 | 24 | 90 | 101 | 190 | 210 | 250 | 91 | 449 | 43 |
| | | Light emitting region (Yb) | 439 | 140 | 240 | 359 | 1938 | 510 | 480 | 140 | 2690 | 630 |
| | | Ya/Yb | 3.8 | 5.8 | 2.7 | 3.6 | 10.2 | 2.4 | 1.9 | 1.5 | 6.0 | 14.7 |
| | L* value of light emitting region (when turned off) | | 9.8 | 9.8 | 7.1 | 10.3 | 9.8 | 10.9 | 10.9 | 22.1 | 12.2 | 13.5 |
| | Visibility (A-D) | | A | A | A | A | A | B | B | C | D | B |

| | | | | | | | | | | | | |
|---|---|---|---|---|---|---|---|---|---|---|---|---|
| (The parts by mass of the colorants are expressed as parts by pass per 100 parts by mass of polyurethane) | | | | | | | | | | | | |

### [Example 2]

A leather-like sheet and a leather-like light-emitting display device were produced and evaluated in the same manner as in Example 1 except that the luminance of the surface-emitting light source was changed as shown in Table 1. The results are shown in Table 1.

### [Example 3]

A leather-like sheet and a leather-like light-emitting display device were produced and evaluated in the same manner as in Example 1 except that the mixing proportion of the colorant in the colored resin sheet was changed as shown in Table 1. The results are shown in Table 1.

### [Example 4]

A leather-like sheet and a leather-like light-emitting display device were produced and evaluated in the same manner as in Example 1 except that VIVITINT BLACK856 was changed to dispersing-type perylene black. The results are shown in Table 1.

### [Example 5]

A leather-like sheet and a leather-like light-emitting display device were produced and evaluated in the same manner as in Example 1 except that the luminance of the surface-emitting light source was changed as shown in Table 1. The results are shown in Table 1.

### [Comparative Example 1]

A leather-like sheet and a leather-like light-emitting display device were produced and evaluated in the same manner as in Example 1 except that the fiber substrate was changed from the PET non-woven fabric to a PET knitted fabric. The results are shown in Table 1.

### [Comparative Example 2]

A leather-like sheet was produced and evaluated in the same manner as in Example 1 except that the average fiber diameter of the fibers forming the PET non-woven fabric of the fiber substrate was changed from 3.0 um to 13.6 um. The results are shown in Table 1.

### [Comparative Example 3]

A resin solution for forming a colored resin sheet was prepared in which a black pigment (carbon black, Dirac L-1770 manufactured by DIC Corporation) was dispersed in a 30 mass% polyurethane DMF solution containing a non-yellowing polycarbonate-based polyurethane. Note that 2.0 mass% of the carbon black relative to the solid content of the non-yellowing polycarbonate-based polyurethane was mixed in the resin solution. Thereafter, a colored resin sheet having a thickness of 60 um was formed in the same manner as in Example 1, and a leather-like sheet and a leather-like light-emitting display device were produced and evaluated in the same manner as in Example 1. The results are shown in Table 1.

### [Comparative Example 4]

A leather-like sheet and a leather-like light-emitting display device were produced and evaluated in the same manner as in Example 1 except that the leather-like sheet was composed only of the colored resin sheet. The results are shown in Table 1.

### [Comparative Example 5]

A leather-like sheet and a leather-like light-emitting display device were produced and evaluated in the same manner as in Comparative Example 4 except that the luminance of the surface-emitting light source was changed as shown in Table 1. The results are shown in Table 1.

Referring to Table 1, the leather-like light-emitting display devices obtained in Examples 1 to 5, which exhibited light-emitting display in which the luminance Ya of the non-light emitting region was 200 cd/m² or less, the luminance Yb of the light-emitting region was 100 to 2,000 cd/m², and Yb/Ya was 2.0 or more, were all evaluated as "A" in the visibility evaluation. On the other hand, Comparative Examples 1 and 2, in which the luminance Ya of the non-light emitting region was greater than 200 cd/m², was evaluated as "B". The leather-like light-emitting display device obtained in Comparative Example 3, which exhibited light-emitting display in which the luminance Ya of the non-light emitting region was 200 cd/m² or less, the luminance Yb of the light-emitting region was 100 to 2,000 cd/m², but Yb/Ya was less than 2.0, was evaluated as "C". The leather-like light-emitting display device obtained in Comparative Example 4, which did not include the fiber substrate, and exhibited light-emission display in which the luminance Ya of the non-light emitting region was greater than 200 cd/m², the luminance Yb of the light-emitting region was also greater than 2,000 cd/m², but Yb/Ya was 2.0 or more, was evaluated as "D". The leather-like light-emitting display device obtained in Comparative Example 5, which did not include the fiber substrate, and exhibited light-emitting display in which the luminance Ya of the non-light emitting region was 200 cd/m² or less, the luminance Yb of the light-emitting region was 100 to 2,000 cd/m², and Yb/Ya was 2.0 or more, was similarly evaluated as "B".

### [Reference Signs List]

- 1: Colored resin layer
- 2: Fiber substrate
- 3: Light-blocking portion
- 10: Leather-like sheet
- 40: Transparent resin layer
- 50: Surface-emitting light source
- 51: Light cover
- 52: LED device
- 53: Surface-mount substrate
- 60, 61: Adhesion layer
- 65: Transparent resin layer
- 70: Light-transmissive leather-like cover
- 100, 110, 120: Leather-like light-emitting display device
- L: Light-emitting region
- NL: Non-light emitting region

## Claims

1. A leather-like light-emitting display device, comprising:
a leather-like sheet that is a laminate of a colored resin layer forming an outer surface layer, and a fiber substrate;
a light-emitting portion disposed below the leather-like sheet; and
a light-blocking portion configured to partially limit transmission of light, and interposed between any layers from the colored resin layer to the light-emitting portion,
wherein the leather-like light-emitting display device is configured to exhibit light-emitting display with a luminance Ya of 200 cd/m² or less in a non-light emitting region corresponding to the light-blocking portion and a luminance Yb of 100 to 2,000 cd/m² in a light-emitting region corresponding to a portion other than the light-blocking portion, both as measured from a surface of the colored resin layer, Yb/Ya being 2.0 or more.

2. The leather-like light-emitting display device according to claim 1,
wherein, while the light-emitting portion is turned off, the light-emitting region has a lightness L* value of 5 or more and 15 or less, as measured from the surface of the colored resin layer under a condition using a D65 light source.

3. The leather-like light-emitting display device according to claim 1 or 2,
wherein the colored resin layer has an average value of light transmittance of 15% or more for the entire visible light range of a wavelength of 380 to 780 nm, and an average value of light transmittance of 50% or more for a range of a wavelength of 680 to 780 nm.

4. The leather-like light-emitting display device according to claim 2 or 3,
wherein the colored resin layer comprises a polyurethane, and a first colorant dispersed in the polyurethane, and the first colorant has an average dispersed particle size of 400 nm or less.

5. The leather-like light-emitting display device according to claim 4,
wherein the first colorant is miscible with the polyurethane at a molecular level.

6. The leather-like light-emitting display device according to claim 4 or 5,
wherein the first colorant is a pigment having a polymer segment bound to a chromophore.

7. The leather-like light-emitting display device according to any one of claims 1 to 6,
wherein the light-blocking portion is a printed layer.

8. The leather-like light-emitting display device according to any one of claims 1 to 7,
wherein the light-blocking portion comprises carbon black.

9. The leather-like light-emitting display device according to any one of claims 1 to 8,
wherein the fiber substrate is a fiber structure comprising fibers having an average fiber diameter of 1.0 to 10.0 um.

10. The leather-like light-emitting display device according to any one of claims 1 to 9,
wherein the light-emitting portion is a surface-emitting device having an emission intensity in a range from 500 to 40,000 cd/m².
